## Europäisches Patentamt

## European Patent Office

## Office européen des brevets

(11) Veröffentlichungsnummer: **0 048 883**
Ä2

(12) **EUROPÄISCHE PATENTANMELDUNG**

(21) Anmeldenummer: 81107242.0

(51) Int. Cl.³: **H 03 F 3/26**, H 03 F 1/34

(22) Anmeldetag: 14.09.81

(30) Priorität: 30.09.80 DE 3036887

(43) Veröffentlichungstag der Anmeldung: 07.04.82
Patentblatt 82/14

(84) Benannte Vertragsstaaten: DE FR GB IT

(71) Anmelder: SIEMENS AKTIENGESELLSCHAFT Berlin und München, Postfach 22 02 61, D-8000 München 22 (DE)

(72) Erfinder: Gehring, Gerhard, Dipl.-Ing, Geschwister-Scholl-Strasse 7, D-8025 Unterhaching (DE)

(54) **Gegenkopplungs-Schaltungsanordnung für einen insbesondere integrierten Transistorverstärker.**

(57) Die Erfindung betrifft eine Gegenkopplungs-Schaltungsanordnung für einen insbesondere integrierten Transistorverstärker, der mit seiner Endstufe ($T_1$, $T_2$) auf einen mit einer Mittelanzapfung versehenen Lastübertrager ($L_{ind}$) arbeitet, wobei die Mittelanzapfung des Lastübertragers ($L_{ind}$) an einer Versorgungsspannung liegt und jeweils ein Ende des Lastübertragers ($L_{ind}$) an einen von jeweils einer Halbwelle' eines Nutzsignals angesteuerten Endstufentransistor ($T_1$, $T_2$) angekoppelt ist und nur während der jeweiligen Halbwelle Laststrom führt. Zur Vermeidung von durch den Lastübertrager ($L_{ind}$) bedingten Phasenproblemen für die Gegenkopplung ist erfindungsgemäß jeweils ein den Strom im Ausgangskreis des jeweiligen Endstufentransistors ($T_1$, $T_2$) abbildender Kreis ($T_3$, $T_4$) und ein Zweig ($R_1$, $R_2$), in den die in den abbildenden Kreisen ($T_3$, $T_4$) fließenden Ströme zu einem Vollwellen-Spannungssignal für die Gegenkopplung kombiniert werden, vorgesehen.

Gegenkopplung zum Verstärkereingang

SIEMENS AKTIENGESELLSCHAFT
Berlin und München

0048883

Unser Zeichen
VPA
80 P 1164 E

Gegenkopplungs-Schaltungsanordnung für einen insbesondere integrierten Transistorverstärker

Die vorliegende Erfindung betrifft eine Gegenkopplungs-
Schaltungsanordnung für einen insbesondere integrierten
Transistorverstärker, der mit seiner Endstufe auf einen
mit einer Mittelanzapfung versehenen Lastübertrager arbeitet, wobei die Mittelanzapfung des Lastübertragers an
einer Versorgungsspannung liegt und jeweils ein Ende des
Lastübertragers an einen von jeweils einer Halbwelle eines Nutzsignals angesteuerten Endstufentransistor angekoppelt ist und nur während der jeweiligen Halbwelle
Laststrom führt.

Starke induktive Lasten, wie beispielsweise Hörer und
Übertrager stellen erhebliche Probleme für die Gegenkoppelbarkeit von Verstärkern dar, wenn das Gegenkopplungssignal direkt an einer derartigen induktiven Last
abgenommen werden muß. Es ergeben sich nämlich erhebliche zusätzliche Phasendrehungen, so daß die Phasenbeziehungen beispielsweise wegen mehrfacher Eigenresonanzen meist sehr undurchsichtig werden.

Dies gilt insbesondere beispielsweise für Gegentaktendstufen von Hörgeräten. Gegentaktendstufen besitzen sehr
viel höhere Wirkungsgrade als Eintaktendstufen. In Hörgeräten kommen jedoch die üblichen Gegentaktendstufen in
Form einer pnp/npn-Transistorkombination nicht in Frage,
weil derartige Schaltungen eine Mindestbatteriespannung
von 1,7 V benötigen. Man arbeitet daher mit angezapften
Hörern und zwei Transistoren des gleichen Leitungstyps
als Endstufen, welche an jeweils ein Ende des Lastübertragers angekoppelt sind. Das Nutzsignal wird dabei so

Lz 1 Reu / 29.9.1980

0048883

aufbereitet, daß jeder Endstufentransistor mit einer Halbwelle des Nutzsignals angesteuert wird und daher nur während einer Halbwelle Strom führt. Das Vollwellen-Signal entsteht erst wieder im Hörer bzw. im Übertrager durch die magnetische Verkopplung beider Zweige.

In mit diskreten Schaltelementen aufgebauten Schaltungsanordnungen dieser Art wurden in bisher üblicher Weise die Bauelemente ausgesucht, ausgemessen, zum Teil abgeglichen und meist mit einer Eigengegenkopplung durch einen Emitterwiderstand betrieben. Dadurch wird jedoch die Aussteuerbarkeit der Endstufe des Transistorverstärkers mehr oder weniger reduziert.

Der vorliegenden Erfindung liegt die Aufgabe zugrunde, eine Gegenkopplungs-Schaltungsanordnung für insbesondere in integrierter Technik ausgebildete Transistorverstärker der in Rede stehenden Art anzugeben, bei der die vorgenannte Reduzierung der Aussteuerbarkeit der Endstufe vermieden wird.

Diese Aufgabe wird bei einer Gegenkopplungs-Schaltungsanordnung der eingangs genannten Art erfindungsgemäß durch folgende Merkmale gelöst: Jeweils einen, den Strom im Ausgangskreis des jeweiligen Endstufentransistors abbildenden Kreis und einen Zweig, in dem die in den abbildenden Kreisen fließenden Ströme zu einem Vollwellen-Spannungssignal für die Gegenkopplung zusammengefaßt werden.

Ausgestaltungen des vorstehend definierten Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt:
Fig. 1 ein Schaltbild einer Ausführungsform einer Endstufe eines Transistorverstärkers mit einer erfindungsgemäßen Gegenkopplungs-Schaltungsanordnung; und

Fig. 2 eine abgewandelte Ausführungsform eines Teils der
Schaltungsanordnung nach Fig. 1.


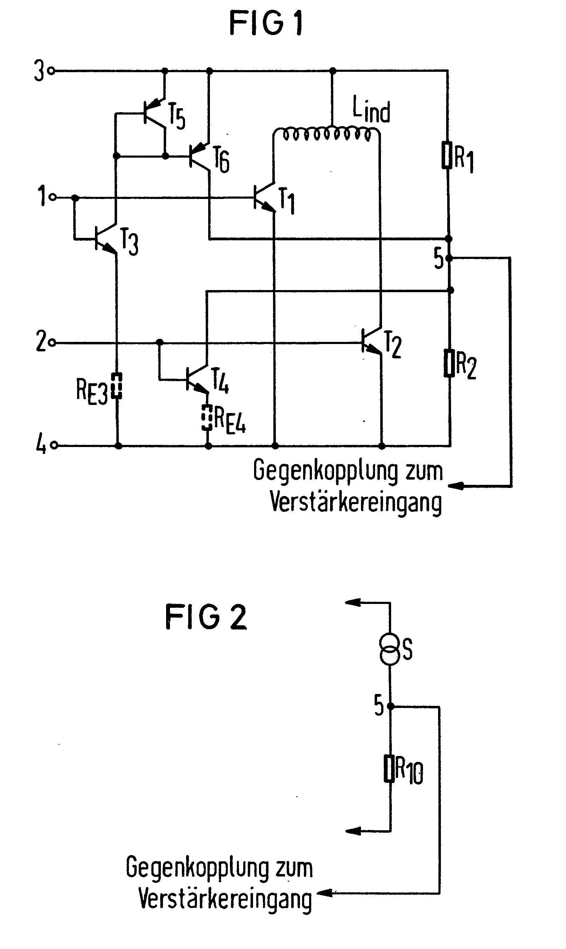

In der Schaltungsanordnung nach Fig. 1 wird eine Endstufe eines Transistorverstärkers, dessen Vorstufen konventionell ausgebildet sein können und daher nicht dargestellt sind, durch Endstufentransistoren $T_1$ und $T_2$ gebildet. Diese Endstufentransistoren $T_1$ und $T_2$ sind an
jeweils ein Ende einer mit einer Mittelanzapfung versehenen induktiven Last $L_{ind}$ angekoppelt, welche beispielsweise durch den Hörer eines Hörgerätes oder durch
einen Übertrager gebildet werden kann. Die Endstufentransistoren $T_1$ und $T_2$ werden an Klemmen 1 und 2 von den
nicht dargestellten Stufen des Transistorverstärkers mit
jeweils einer Halbwelle eines Nutzsignals angesteuert.
Die Schaltung wird an Klemmen 3 und 4 mit einer Betriebsspannung versorgt, wobei die Klemme 3 eine positive Betriebsspannung führt und die Klemme 4 auf Bezugspotential (Masse) liegt.


Zur Erzeugung eines Gegenkopplungssignals wird nun zunächst die Basis-Emitterspannung der Endstufentransistoren $T_1$ und $T_2$ durch jeweils einen Abtast-Transistor $T_3$
bzw. $T_4$ erfaßt. Dies beruht auf der Tatsache, daß die
Basis-Emitterspannung der Endstufentransistoren $T_1$ und
$T_2$ eine Funktion des Ausgangsstroms ist und mit diesem
logarithmisch ansteigt. An der Basis-Emitterstrecke der
Endstufentransistoren steht daher eine Information über
den tatsächlich fließenden Ausgangsstrom zur Verfügung,
ohne daß dabei in den Lastkreis eingegriffen und ohne
daß die Impedanzverhältnisse im Lastkreis beispielsweise
durch Emitterwiderstände verändert werden müssen.


In integrierten Schaltungen gestaltet sich diese Erfassung bzw. Auswertung der Basis-Emitterspannung der Endstufentransistoren $T_1$ und $T_2$ besonders einfach. Werden
die Abtast-Transistoren $T_3$ und $T_4$ gemäß einem besonderen
Merkmal der Erfindung im gleichen Halbleiterkristall in
unmittelbarer Nähe des jeweiligen Endstufentransistors
$T_1$ bzw. $T_2$ angeordnet, so liefern die Abtast-Transistoren
unter der Voraussetzung gleicher Geometrie bei gleicher
Basis-Emitterspannung denselben Strom wie die Endstufentransistoren $T_1$ und $T_2$. Bei kleineren Abmessungen der Abtast-Transistoren in Bezug auf die Endstufentransistoren
ist der Strom um einen definierten Faktor kleiner.

Bei Abtastung bzw. Erfassung der Ströme in den Endstufentransistoren $T_1$ und $T_2$ in der vorstehend beschriebenen
Weise läßt sich ohne Spannungsabfälle an Emitterwiderständen ein exaktes Abbild der Ausgangsströme mit allen
durch die induktive Last $L_{ind}$ bedingten Verzerrungen gewinnen und für eine Gegenkopplung zur Verbesserung der
Linearität benutzen, ohne daß dabei die Phasenprobleme
aufgrund der induktiven Last berührt werden.

Bei einer Gegentaktendstufe der dargestellten Art mit
einer mit einer Mittelanzapfung versehenen induktiven
Last $L_{ind}$ ist es allerdings erforderlich, zunächst beide Halbwellen des Nutzsignals wieder zu einem Vollwellen-
Nutzsignal zusammenzufügen. Der im Abtast-Transistor $T_3$
fließende Strom, welcher die eine Halbwelle abbildet,
wird zunächst in einem durch Transistoren $T_5$ und $T_6$ gebildeten Stromspiegel an der positiven Batteriespannung
(Klemme 3) gespiegelt und sodann in einem durch einen
Spannungsteiler $R_1$ und $R_2$ gebildeten Zweig eingespeist,
während der Strom im Transistor $T_4$, welcher die andere
Halbwelle des Nutzsignals abbildet, direkt in diesen
Zweig eingespeist wird. Im Zweig $R_1$, $R_2$ werden diese
Ströme zu einem Vollwellen-Spannungssignal für die Gegenkopplung kombiniert. Dieses Signal ist an einem Punkt 5
abnehmbar und in konventioneller und daher nicht näher

0048883

dargestellten Weise in den Verstärkereingang zur Gegenkopplung einspeisbar.

Steigt der durch das Nutzsignal gebildete Signalstrom während der ersten Halbwelle an, so steigt auch die Signalspannung bzw. Gegenkopplungsspannung am Punkt 5, d. h., am Abgriff des Spannungsteilers $R_1$, $R_2$ in positiver Richtung an. Steigt dagegen der Strom während der zweiten Halbwelle des Nutzsignals in der anderen Endstufe an, so fällt die Spannung am Abgriff 5 in negativer Richtung. Es ergibt sich daher am Punkt 5 ein Vollwellen-Spannungssignal, dem eine Gleichspannung überlagert ist, die am Spannungsteiler als Teil der Batteriespannung entsprechend dem Widerstandsverhältnis des Spannungsteilers abfällt.

Am Punkt 5 kann daher das Vollwellen-Spannungssignal, das eine exakte Abbildung der Ausgangsströme darstellt, für die Gegenkopplung des Gegentaktverstärkers ohne Störung durch einen die induktive Last $L_{ind}$ bildenden Hörer oder Übertrager abgenommen werden.

Zur Wiedergewinnung des Vollwellen-Spannungssignals ist es nicht unbedingt erforderlich mit einem Spannungsteiler gemäß Fig. 1 zu arbeiten. Es genügt vielmehr auch, mit einem einzigen Widerstand zu arbeiten.

Eine derartige Möglichkeit ist in Fig. 2 dargestellt, wobei dieser Schaltungsteil den Spannungsteiler $R_1$, $R_2$ nach Fig. 1 ersetzt, der Gleichspannungspegel, welcher an einem einzigen Widerstand $R_{10}$ nach Fig. 2 erforderlich ist, damit auch die negative Halbwelle des Nutzsignals ausgesteuert werden kann, entsteht als Spannungsabfall durch einen von einer Konstantstromquelle S gelieferten Konstantstrom der von der positiven Batteriespannung (Klemme 3 in Fig. 1) eingespeist wird. Der Gleichspannungspegel ist in diesem Fall unabhängig von der Versorgungsspannung.

In praktischer Ausführung der vorstehend beschriebenen und dargestellten Schaltungsanordnung kann gemäß einer Weiterbildung der Erfindung als Ausgleich für die Bahnwiderstände der Endstufentransistoren $T_1$ und $T_2$, welche eine etwas erhöhte Basis-Emitterspannung bewirken, jeweils noch ein kleiner Emitterwiderstand $R_{E3}$ und $R_{E4}$ vorgesehen werden, die, da nicht unbedingt erforderlich, gestrichelt dargestellt sind.

6 Patentansprüche

2 Figuren

0048883

## Patentansprüche

1. Gegenkopplungs-Schaltungsanordnung für einen insbesondere integrierten Transistorverstärker, der mit seiner Endstufe auf einen mit einer Mittelanzapfung versehenen Lastübertrager arbeitet, wobei die Mittelanzapfung des Lastübertragers an einer Versorgungsspannung liegt und jeweils ein Ende des Lastübertragers an einen von jeweils einer Halbwelle eines Nutzsignals angesteuerten Endstufentransistor angekoppelt ist und nur während der jeweiligen Halbwelle Laststrom führt, g e k e n n - z e i c h n e t   d u r c h   jeweils einen, den Strom im Ausgangskreis des jeweiligen Endstufentransistors ($T_1$, $T_2$) abbildenden Kreis ($T_3$, $T_4$), und durch einen Zweig ($R_1$, $R_2$; S, $R_{10}$), in dem die in den abbildenden Kreisen ($T_3$, $T_4$) fließenden Ströme zu einem Vollwellen-Spannungssignal für die Gegenkopplung zusammengefügt werden.

2. Schaltungsanordnung nach Anspruch 1, d a d u r c h g e k e n n z e i c h n e t , daß der Zweig ($R_1$, $R_2$), in dem die in den abbildenden Kreisen ($T_3$, $T_4$) fließenden Ströme zu einem Vollwellen-Spannungssignal für die Gegenkopplung zusammengefügt werden, durch einen Spannungsteiler gebildet ist.

3. Schaltungsanordnung nach Anspruch 1, d a d u r c h g e k e n n z e i c h n e t , daß der Zweig (S, $R_{10}$), in dem die in den abbildenden Kreisen ($T_3$, $T_4$) fließenden Ströme zu einem Vollwellen-Spannungssignal für die Gegenkopplung zusammengefügt werden, durch einen Widerstand ($R_{10}$) und eine Stromquelle gebildet ist.

4. Schaltungsanordnung nach einem der Ansprüche 1 bis 3, d a d u r c h g e k e n n z e i c h n e t , daß die den Strom des jeweiligen Endstufentransistors ($T_1$, $T_2$) abbildenden Kreise durch jeweils eine von der Basis-Emitterspannung des Endstufentransistors ($T_1$, $T_2$) angesteuer-

te Abtast-Transistorstufe ($T_3$, $T_4$) gebildet sind und daß für eine für die Erzeugung des Vollwellen-Spannungssignals notwendige Vorzeichenumkehr in einer der Abtast-Transistorstufen ($T_3$) ein Stromspiegel ($T_5$, $T_6$) vorgesehen ist.

5. Schaltungsanordnung nach einem der Ansprüche 1 bis 4, d a d u r c h   g e k e n n z e i c h n e t ,   daß die Abtast-Transistorstufen ($T_3$, $T_4$) durch jeweils einen in Emitterschaltung betriebenen Transistor gebildet sind, der bei Ausführung in integrierter Technik in einem Halbleiterkristall unmittelbar benachbart zum zugehörigen Endstufentransistor ($T_1$ bzw. $T_2$) angeordnet ist.

6. Schaltungsanordnung nach einem der Ansprüche 1 bis 5, d a d u r c h   g e k e n n z e i c h n e t ,   daß im Emitterzweig der Abtast-Transistoren ($T_3$, $T_4$) jeweils ein Widerstand ($R_{E3}$, $R_{E4}$) liegt.

0048883

1/1

FIG 1

FIG 2

Gegenkopplung zum
Verstärkereingang